# EUROPEAN PATENT APPLICATION

(11) **EP 4 668 319 A1**
(43) Date of publication of application: **24.12.2025**
(21) Application number: 24183356.5
(22) Date of filing: 20.06.2024
(51) Int. Cl.: H01L 21/48, H01L 23/14, H01L 23/538, H01L 23/00, H01L 25/065, H01L 25/00

(54) **A METHOD FOR PRODUCING A SEMICONDUCTOR COMPONENT ASSEMBLY**

(71) Applicant: Imec VZW, 3001 Leuven (BE)
(72) Inventor: Miller, Robert, 3210 Lubbeek (BE); Jafarpoorchekab, Hamideh, 3001 Heverlee (BE); Pinho, Nelson, 3001 Heverlee (BE); Sun, Xiao, 3012 Wilsele (BE); Sinha, Siddhartha, 3010 Kessel-Lo (BE)
(74) Representative: Patent Department IMEC

(57) **Abstract**

The method of the invention is related to the assembly of two components on two opposite sides of a substrate (1), enabled by the embedding of one of the components in a stress-compensated SiO₂ layer (14) applied at low temperatures, i.e. lower than any temperature that could compromise the functionality of the embedded component. Preferred embodiments are related to heterogeneous integration schemes, i.e. the assembly of components of different types, such as a CMOS chip (12) and a III-V chip (22), which are otherwise difficult to integrate in a 3D package. The stress-compensated film (14) embeds the component at least laterally, i.e. the layer surrounds and is in direct contact with the sides of the component and the thickness of the film is at least equal to the thickness of the component.

## Description

### Field of the Invention

The invention is related to the field of semiconductor processing, in particular to the semiconductor component assembly, also referred to as packaging.

### State of the art.

A development that continues to gain prominence in the semiconductor industry is the so-called heterogeneous integration packaging, i.e. the integration of non-silicon-based components like III-V based dies with silicon-based components like CMOS chips into a complete system. One area of interest in this regard is the development of wireless communication solutions which will power future generations of telecom devices.

Current heterogeneous integration schemes include so-called 2.5D schemes, wherein for example a III-V chip and a CMOS chip are bonded side by side on an interposer substrate. This scheme enables good thermal management as both chips can be in contact with the same heat sink. However, it intrinsically involves horizontal interconnect lines which lead to unacceptable losses at high frequencies applicable in RF (radio frequency) applications. Also, in 5G and future 6G applications, 2D beam steering becomes a requirement, which is possible only when applying 3D heterogeneous integration schemes, wherein for example a III-V chip is mounted on top of a CMOS chip. The thermal management of these 3D configurations is however problematic.

### Summary of the invention

The invention aims to provide a method for assembling semiconductor components which does not suffer from the above problems. The method of the invention is related to the assembly of two components on two opposite sides of a substrate, enabled by the embedding of one of the components in a stress-compensated SiO₂ layer applied at low temperatures, i.e. lower than any temperature that could compromise the functionality of the embedded component. Preferred embodiments are related to heterogeneous integration schemes, i.e. the assembly of components of different types, such as a CMOS (complementary metal-oxide semiconductor) chip and a III-V chip, which are otherwise difficult to integrate in a 3D package. Another example of heterogeneous integration to which the invention is applicable is the integration of a CMOS chip combined with a MEMS (micro-electromechanical system) chip.

The stress-compensated film embeds the component at least laterally, i.e. the layer surrounds and is in direct contact with the sides of the component and the thickness of the film is at least equal to the thickness of the component. The method preferably includes depositing the stress-compensated film followed by planarizing the film to a level parallel to and possibly coinciding with the component's upper surface. This may include thinning the component and the film together to a common planarized level.

The fact that the stress-compensated film is applied at temperatures which do not compromise the functionality of the component embedded in said film, together with the fact that the film is stress-compensated enables mounting the component on one side of the substrate and continuing to process said substrate on the opposite side thereof, without unallowable warping of the substrate.

The components on opposite side of the substrate are partly overlapping and are electrically interconnected by through semiconductor vias through the substrate. This assembly thereby represents a 3D packaging solution that enables the use of short low-loss interconnects and enables 2D beam steering when combining a CMOS chip and III-V component in an RF package. For 2D beam steering it is needed to follow the half wavelength pitch in both X and Y directions. The half wavelength pitch scales with frequency and is typically smaller than the combined size of the III-V and CMOS component at mm-wave frequencies. Therefore, placing the III-V and CMOS on opposite sides of the semiconductor package will allow to save space and follow the half wavelength pitch. At the same time, the components are not directly bonded to each other so that thermal management problems related to such direct bonding configurations are avoided.

The invention is in particular related to a method for assembling and interconnecting a first and a second semiconductor component, said components having predefined functionalities, the method comprising the steps of :
- providing a semiconductor substrate having a front side and a back side,
- producing a plurality of through semiconductor vias at the front side of the substrate, said vias reaching down to a given depth that is smaller than the substrate's thickness,
- producing a first redistribution layer on the front side of the semiconductor substrate, said first redistribution layer comprising electrical connections to said vias, and further comprising on its upper surface a plurality of first contact pads,
- thinning the substrate from the back side thereof, until the through semiconductor vias are exposed,
- producing a second redistribution layer on the back side of the thinned semiconductor substrate, said second redistribution layer comprising electrical connections to said vias, and further comprising on its upper surface a plurality of second contact pads,
characterised in that the method further comprises :
- bonding the first component to one of said first and second redistribution layers directly after producing said one of the redistribution layers, by a bonding method configured to realize electrical connections between a number of said first or second contact pads of the respective first or second redistribution layer and corresponding contact pads on the first component,
- after bonding the first component to said one of the redistribution layers, producing a silicon dioxide film at a temperature that is compatible with the functionality of the first component, said silicon dioxide film comprising a sequence of mutually stress-compensating layers, wherein said film embeds the first component at least laterally,
- bonding the second component to the other of the first and second redistribution layers directly after producing said other of the redistribution layers, by a bonding method configured to realize electrical connections between a number of said first or second contact pads of the respective first or second redistribution layer and corresponding contact pads on the second component, and wherein the second component is at least partially overlapping the first component.

According to an embodiment, the first component has a given thickness and a planar upper surface, and producing said silicon dioxide film includes :
- depositing said sequence of mutually stress-compensating layers to form a layer stack covering the first component and having a thickness at least equal to the thickness of the first component,
- planarizing the layer stack so that the upper surface of the planarized layer stack is parallel to the upper surface of the first component, and wherein the planarized layer stack constitutes said silicon dioxide film.

According to an embodiment, said planarizing step includes exposing the upper surface of the first component.

According to an embodiment, the planarizing step includes simultaneously thinning the first component and the layer stack.

According to an embodiment, the first component and the second component are different types of semiconductor components.

According to an embodiment, the first component is a silicon CMOS chip and the second component is a III-V chip.

According to an embodiment, the method further comprises the step of attaching an antenna chip to the III-V chip, after said III-V chip has been bonded to said first redistribution layer.

According to an embodiment, the method further comprises the step of producing one or more through dielectric vias through the thickness of the silicon dioxide film.

According to an embodiment, the first and/or the second component are bonded respectively to said one and said other of the redistribution layers by hybrid bonding.

According to an embodiment, the first and/or the second component are bonded respectively to said one and said other of the redistribution layers by solder bonding.

### Brief description of the figures

Figures 1 to 19 illustrate key steps in the production process for producing a component assembly in accordance with an embodiment of the invention.
Figure 20 illustrates a possible implementation of a package comprising said component assembly.

### Detailed description of the invention

One embodiment of the method of the invention will be described in detail, although the invention is not limited to the particular configuration produced by this embodiment. The embodiment concerns a telecommunication package comprising a CMOS chip and a III-V chip coupled to an antenna, wherein the CMOS chip and the III-V chip are interconnected electrically in a manner to enable signal processing of radio frequency signals received through the antenna and to generate signals for transmission by the antenna. The chips as such as well as the antenna may be in accordance with known technology. The characteristic features of the invention are defined by specific method steps applied during the assembly of the package, as described hereafter.

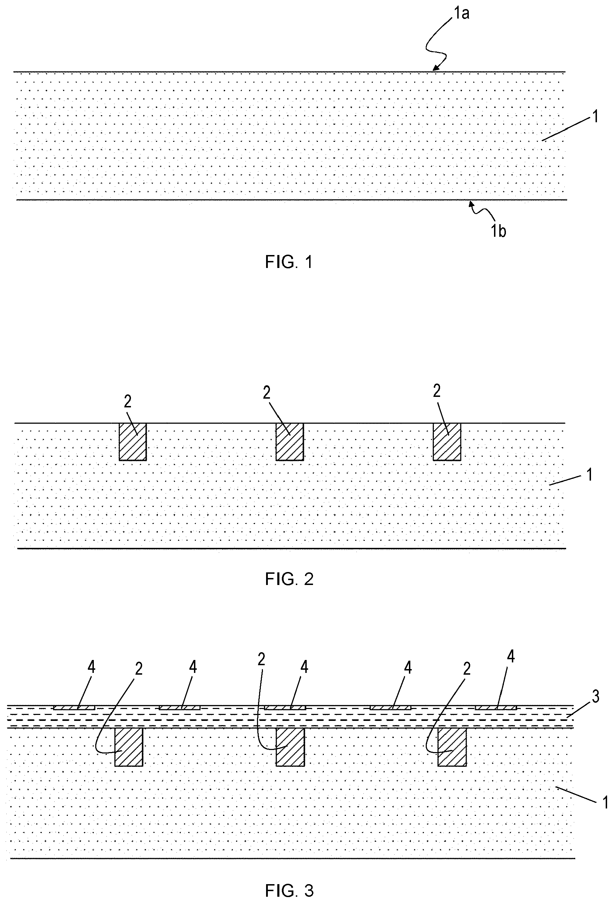

With reference to Figure 1, a semiconductor substrate 1 is provided having a thickness of about 400 µm. The substrate may be thicker, for example it may be a standard silicon process wafer of 200 mm or 300 mm in diameter and with a thickness respectively of 725 µm or 775µm.

The image shows a cross section of a small portion of the substrate 1. The substrate has a front side 1a and a back side 1b. As shown in Figure 2, a plurality of through semiconductor vias 2 are produced in the substrate 1, at the front side thereof. These are pillar-shaped electrical connections which may have a height of about 100 µm for example. The vias 2 can be produced by known methods including lithography and etching for creating pillar-shaped cavities, and electroplating or other deposition techniques, for filling the cavities with an electrically conductive material, preferably a metal such as copper. Details of such techniques are well-known and therefore not described here. A planarization technique, equally well-known as such, is applied for planarizing the upper surface of the substrate 1 so that the upper surfaces of the vias 2 are at the same level as the substrate surface, as illustrated in Figure 2.

With reference to Figure 3, a redistribution layer 3 is produced on the common planarized surface of the substrate 1 and the vias 2. A redistribution layer is defined within the present context as a multilevel interconnect structure comprising via connections and horizontal interconnect lines embedded in stacked layers of dielectric material. Such a multilevel structure is well known from back end of line processing in the semiconductor industry, and can be produced by known techniques such as damascene-type processing steps. Details of the redistribution layer 3 are not shown in the drawing, except for the presence of contact pads 4 which are coplanar with the upper surface of the redistribution layer 3. The contact pads 4 are electrically connected to one or more of the vias 2 through conductors within the redistribution layer 3, arranged according to a given layout designed to enable said electrical connections.

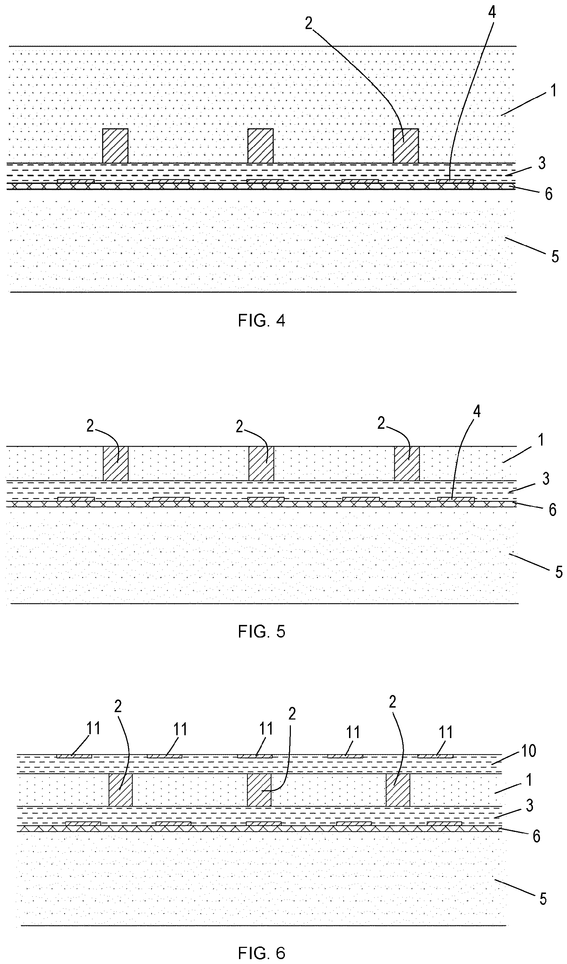

The substrate 1 is then flipped and attached face-down to a carrier substrate 5 through a temporary bonding layer 6, as illustrated in Figure 4. The temporary bonding layer 6 is formed of a removable adhesion material known as such. The substrate 1 is subsequently thinned from the back side, until the vias 2 are exposed, as illustrated in Figure 5. This may be done by known grinding and planarization techniques, such as chemical mechanical polishing, possibly thinning the vias 2 to a small degree so that these vias are exposed in the planarized back surface of the thinned substrate 1.

A second redistribution layer 10 is then produced on the thinned backside of the substrate 1, as illustrated in Figure 6. The second redistribution layer 10 equally includes a number of interconnect levels, and a plurality of contact pads 11 which are coplanar with the upper surface of said second redistribution layer 10.

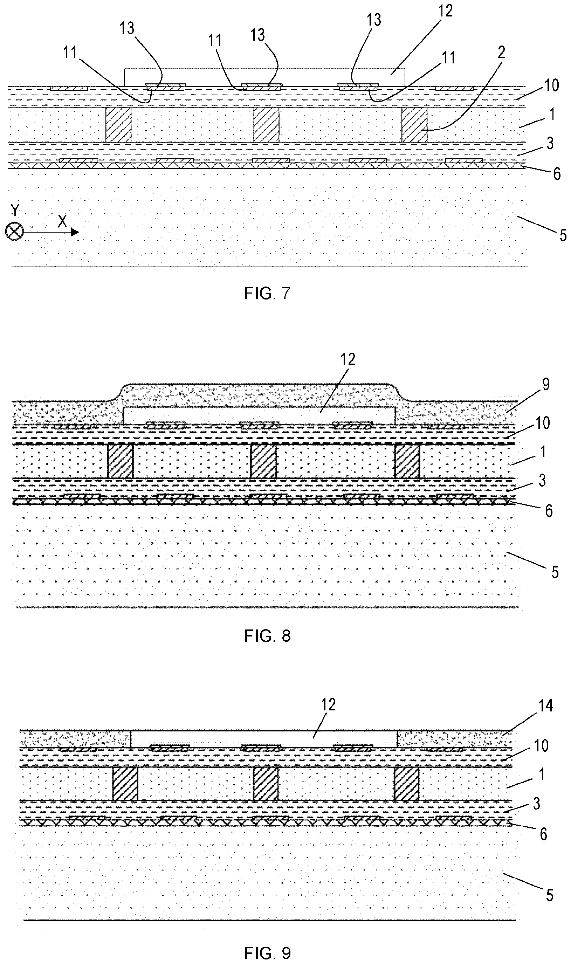

As shown in Figure 7, a CMOS chip 12 is bonded to the planar upper surface of the second redistribution layer 10, by a suitable bonding technique. In the embodiment shown, the applied technique is known as hybrid bonding but another bonding technique can be used as well, such as for example solder bonding or any other technique known to the person skilled in the art. The chip 12 comprises a number of contact pads 13 embedded in a dielectric material. By the hybrid bonding technique, the bonding surfaces are brought together, both surfaces consisting of dielectric material with the respective contact pads 11 and 13 embedded therein. The bond that is realized is a direct dielectric-to-dielectric bond and metal-to-metal bond between the respective corresponding materials, realized by mutual alignment of the contact pads 11 and 13 and by the application of a suitable bonding temperature and possibly a bonding pressure. Details of the hybrid bonding technique are known as such and therefore not described here in further detail.

The chip 12 represented in the drawings is not necessarily drawn to scale. The lateral dimensions of the chip 12 could be larger than shown in the drawing and the number of contact pads 13 on the CMOS chip 12 and the corresponding number of pads 11 on the substrate 1 could be much higher than the number illustrated in the drawing. The contact pads 11 and 13 could be arranged in a rectangular array extending in the X and Y directions indicated in Figure 7. The height of the CMOS chip 12 may be in the order of a few tens of micrometres, for example about 50 µm.

With reference to Figure 8, the CMOS chip 12 is embedded in a layer stack 9 of silicon dioxide (SiO₂) layers. The SiO₂ layer stack 9 is formed by a specific technique, wherein consecutive layers of SiO₂ are formed by chemical vapour deposition steps, applying deposition temperatures which are compatible with the functionality of the CMOS chip 12. In other words, the deposition temperature is lower than any temperature that could compromise the chip's functionality. Preferably, the deposition temperature is lower than 400°C. It may be required to lower the deposition temperature towards even lower temperatures based on specific considerations other than the preservation of the chip's functionality. For example, if the temporary bonding layer 6 is an organic bonding layer, the deposition temperature is preferably below 250°C in order not to compromise the temporary bonding force.

The deposition of the consecutive SiO₂ layers is furthermore tuned so that the layers are alternately subjected to tensile and compressive stresses, at stress levels configured so that the film as a whole is essentially stress-compensated, i.e. the net stress level in the layer stack 9 is minimal during subsequent processing steps, so that warping of the substrate 1 during said processing steps is minimized.

Methods for producing such a stress-compensated multilayer SiO₂ stack 9 are known as such, and disclosed for example in patent publication document US9472610.

As illustrated in Figure 8, after the deposition of the stress-compensated layer stack 9, this layer stack 9 covers the surface of the second redistribution layer 10, and the sidewalls and upper surface of the CMOS chip 12. The thickness of the layer stack 9 is higher than the thickness of the CMOS chip 12. The layer stack 9 follows the topology of the CMOS chip 12.

The next step, illustrated in Figure 9, is a planarization step that reduces the thickness of the layer stack 9 to the thickness of the chip 12, for example at about 50 µm. The chip is now laterally embedded in the stress-compensated SiO₂ film 14 (said film 14 is the planarized and thinned layer stack 9).

According to an alternative embodiment, the layer stack 9 is not thinned to the level of the chip's upper surface, but the layer stack is planarized to a level above the upper surface of the chip 12, so that said upper surface is not exposed. This may be beneficial as it provides more mechanical stability to the eventual package. However it is also possible to partially thin down the chip together with the layer stack 9. The latter option or the embodiment illustrated in the drawings, wherein the layer stack 9 is thinned down and planarized to the level of the chip's upper surface, is more beneficial in terms of heat removal, as the surface of the chip is not covered by a heat-insulating SiO₂ layer in these cases.

According to preferred embodiments, a chip 12 is provided having rounded edges, which is beneficial in terms of minimizing local stress concentrations in the SiO₂ film 14 in the vicinity of said edges.

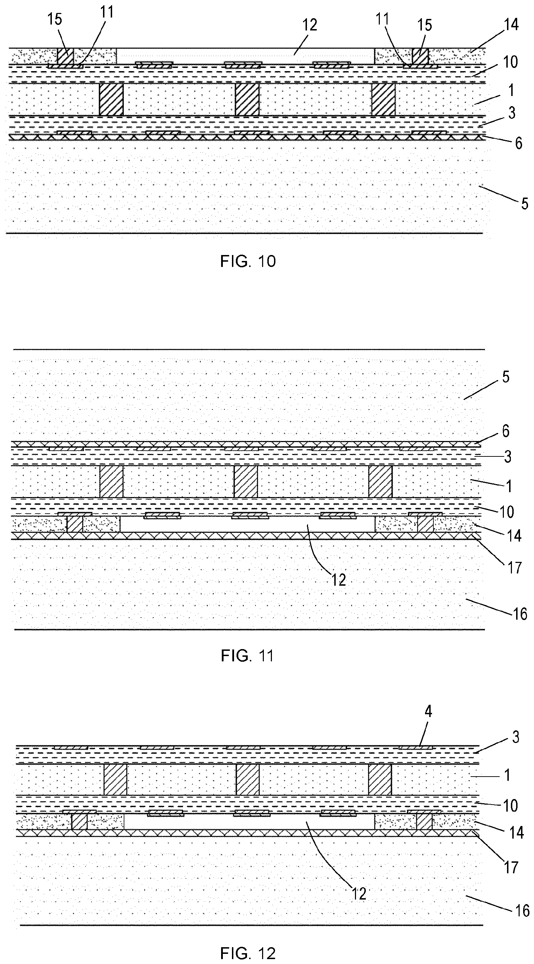

With reference to Figure 10, via connections 15 may be produced through the SiO₂ film 14, and connected to respective contact pads 11 of the second redistribution layer 10. These via connections 15 can be produced by known lithography, etch and metal fill processes, which may involve the creation of via openings and the filling of these openings with metal such as copper, followed by planarization to bring the upper surface of the vias 15 to the same level as the upper surface of the CMOS chip 12, or to the level of the planarized surface of the SiO₂ film 14 if a given thickness of SiO₂ remains above the chip 12.

The carrier substrate 5 with the thinned substrate 1 attached thereto is then flipped and bonded face down to a second carrier substrate 16, again by a temporary bonding layer 17, as shown in Figure 11, after which the first carrier 5 and the first temporary bonding layer 6 are stripped, resulting in the image shown in Figure 12.

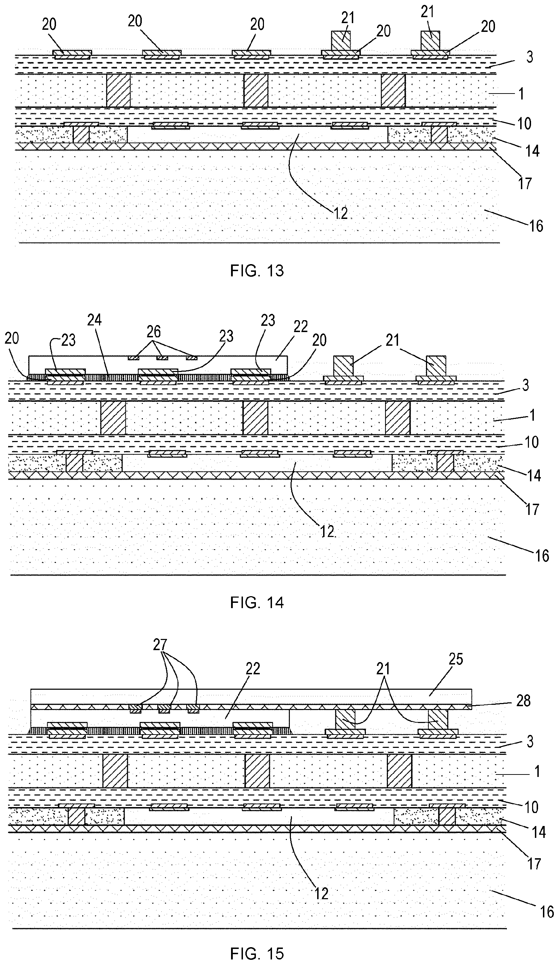

The first redistribution layer 3 and the contact pads 4 embedded therein are now again exposed. With reference to Figure 13, bonding pads 20 are produced respectively on the contact pads 4. These bonding pads are also known as so-called under bump metal (UBM) pads suitable for receiving thereon a solder material for establishing solder connections. Materials of these pads 20 and methods steps for producing the pads 20 are known as such.

In the illustrated embodiment, some of the UBM pads 20 are provided with conductive pillars 21 of several tens of micrometers in height, formed also according to known methods. Both the UBM pads 20 and the pillars 21 can for example be produced by a known semi-additive fabrication method.

Then, the III-V chip 22 is bonded to the first redistribution layer 3 by solder bonding, as illustrated in Figure 14. The III-V chip comprises contact pads 23 which are aligned to corresponding UBM pads 20 on the first redistribution layer 3 and the bond is established by solder bumps interposed between the contact pads 23 and the UBM pads 20 and by a suitable solder anneal process inducing the solder to melt and form intermetallic compounds with the UBM and contact pad materials. After the formation of the solder bonds, an underfill material 24 is applied, as also known generally in the art. According to alternative embodiments, the III-V chip 22 may be bonded to the first redistribution layer 3 by hybrid bonding as described above.

With reference to Figure 15, the next step concerns the attachment of an antenna chip 25 to the back side of the III-V chip 22. The III-V chip 22 comprises back side contacts 26 configured to be connected to corresponding contacts 27 on the antenna chip 25 . The antenna chip 25 is attached to the III-V chip 22 by an adhesive layer 28. The lateral dimensions of the antenna chip 24 are such that the antenna chip overlaps both the footprint of the III-V chip 22 on the first redistribution layer 3 and of the CMOS chip 12 on the second redistribution layer 10. In the embodiment shown, the antenna chip 24 is supported by at least two of the Cu pillars 21, as shown in Figure 15. In this particular case, these two pillars do not establish an electrical connection but they are mainly included to provide mechanical support for the antenna 25. It is however also possible to realize a configuration wherein at least some of the pillars 21 are effectively serving as electrical connections.

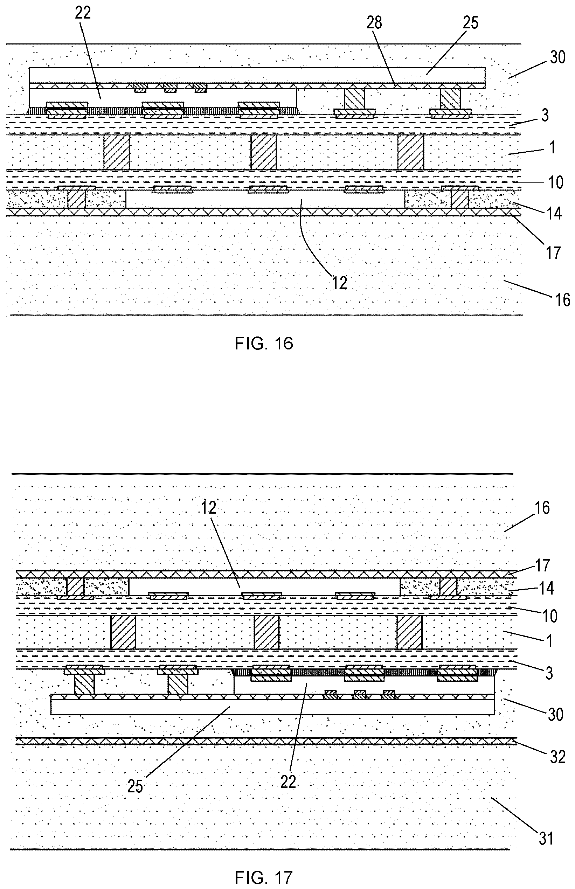

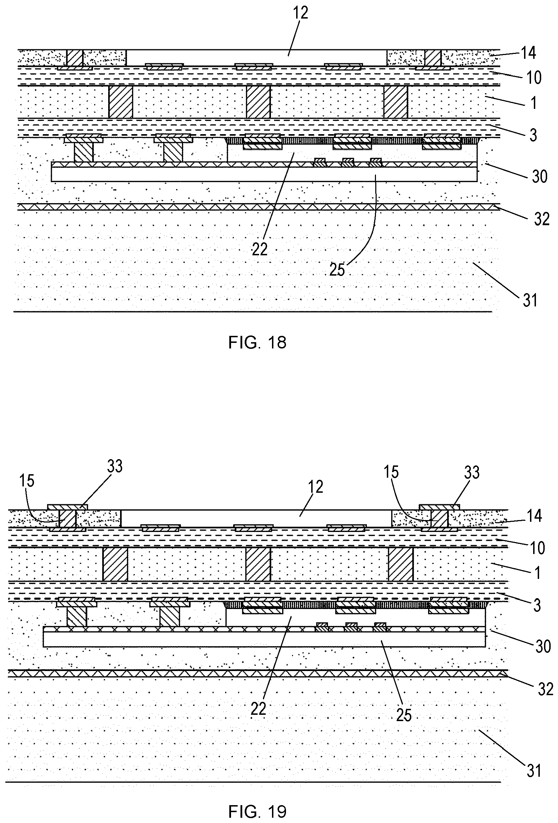

Following this and with reference to Figure 16, the antenna chip 25 is encapsulated in a dielectric layer 30. This may be a polymer for example, with a dielectric constant lower than 2. The second carrier substrate 16 is then flipped and temporarily bonded to a third carrier substrate 31 by a further temporary bonding layer 32, as shown in Figure 17, followed by the removal of the second carrier 16 and its temporary bonding layer 17, resulting in the image shown in Figure 18. The CMOS chip 12 and its embedding SiO₂ layer 14 are now again exposed.

The method steps described so far result in the fabrication of an assembly comprising the IC chip 12 and the III-V chip 22, bonded on opposite sides of an interposer substrate (this is the thinned original substrate 1 provided with redistribution layers 3 and 10 on both sides thereof). The chips 12 and 22 are partly overlapping and are electrically interconnected by through semiconductor vias 2 through the interposer. This assembly thereby represents a 3D packaging solution that enables the use of short low-loss interconnects and 2D beam steering. At the same time, the III-V chip 22 is not bonded directly to the CMOS chip 12, so that thermal management problems related to such direct bonding configurations are avoided.

The method feature that enables the production of this type of assembly is the application of the stress compensated SiO₂ film 14 embedding the CMOS chip 12. The fact that this layer is applied at temperatures which do not compromise the functionality of the CMOS chip 12, together with the fact that the layer 14 is stress-compensated enables mounting the CMOS chip 12 on one side of the substrate 1 and continuing to process said substrate on the opposite side thereof, without unallowable warping of the substrate.

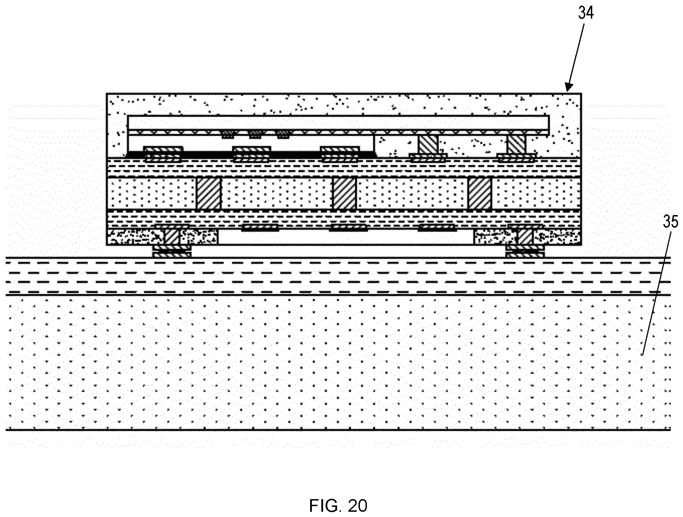

The assembly can be subsequently further processed, for example as illustrated in Figures 19 and 20. UBM pads 33 can be applied to the vias 15, as shown in Figure 19. Alternatively, these pads 33 could be produced earlier in the process sequence, at the stage shown in Figure 10.

The assembly 34 can then be separated by singulation and bonded, for example by solder bonding, to a larger carrier such as a PCB 35, as illustrated in Figure 20.

As stated, the invention is not limited to the particular embodiment illustrated in the drawings. In its most general description, the method of the invention is related to the assembly of two components on two opposite sides of an interposer substrate, enabled by the embedding of one of the components in a stress-compensated SiO₂ layer applied at low temperatures, i.e. lower than any temperature that could compromise the functionality of the embedded component. Preferred embodiments are related to the heterogeneous integration schemes, i.e. the assembly of components of different types, such as the CMOS chip and the III-V chip, which are otherwise difficult to integrate in a 3D package. The method of the invention is however applicable to the integration of components of any type, the same or different, mounted on opposite sides of the interposer substrate.

According to an alternative process flow, the CMOS chip 12 is bonded to the first redistribution layer 3 after the production thereof, i.e. at the process stage illustrated in Figure 3. Thereafter, the chip 12 is embedded in the stress-compensated SiO₂ film 14 in the same manner as described above. The substrate is then flipped and temporarily bonded to a first carrier, i.e. with the planarized surface of the stress-compensated film 14 bonded to said carrier through a temporary adhesion layer. The substrate is then thinned from the back side, and the second redistribution layer 10 is produced on the thinned back side, followed by bonding the III-V chip 22 to the second redistribution layer 10. The antenna 25 can be added in the same way as described above. The advantage of this approach is that only one auxiliary carrier substrate is required. Like the flow shown in the drawings, this alternative process flow is not limited to heterogeneous integration schemes but can be applied to the integration of components of any type, the same or different, mounted on opposite sides of the interposer substrate.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A method for assembling and interconnecting a first and a second semiconductor component (12,22), said components having predefined functionalities, the method comprising the steps of :
- providing a semiconductor substrate (1) having a front side (1a) and a back side (1b),
- producing a plurality of through semiconductor vias (2) at the front side of the substrate (1), said vias reaching down to a given depth that is smaller than the substrate's thickness,
- producing a first redistribution layer (3) on the front side of the semiconductor substrate (1), said first redistribution layer comprising electrical connections to said vias (2), and further comprising on its upper surface a plurality of first contact pads (4),
- thinning the substrate (1) from the back side thereof, until the through semiconductor vias (2) are exposed,
- producing a second redistribution layer (10) on the back side of the thinned semiconductor substrate (1), said second redistribution layer comprising electrical connections to said vias (2), and further comprising on its upper surface a plurality of second contact pads (11),
**characterised in that** the method further comprises :
- bonding the first component (12) to one of said first and second redistribution layers (3,10) directly after producing said one of the redistribution layers, by a bonding method configured to realize electrical connections between a number of said first or second contact pads (4,11) of the respective first or second redistribution layer (3,10) and corresponding contact pads (13) on the first component (12),
- after bonding the first component to said one of the redistribution layers (3,10), producing a silicon dioxide film (14) at a temperature that is compatible with the functionality of the first component (12), said silicon dioxide film comprising a sequence of mutually stress-compensating layers, wherein said film (14) embeds the first component (12) at least laterally,
- bonding the second component (22) to the other of the first and second redistribution layers (3,10) directly after producing said other of the redistribution layers, by a bonding method configured to realize electrical connections between a number of said first or second contact pads (4,11) of the respective first or second redistribution layer (3,10) and corresponding contact pads (23) on the second component (22), and wherein the second component (22) is at least partially overlapping the first component (12).

2. The method according to claim 1, wherein the first component (12) has a given thickness and a planar upper surface, and wherein producing said silicon dioxide film (14) includes :
- depositing said sequence of mutually stress-compensating layers to form a layer stack (9) covering the first component (12) and having a thickness at least equal to the thickness of the first component (12),
- planarizing the layer stack (9) so that the upper surface of the planarized layer stack is parallel to the upper surface of the first component (12), and wherein the planarized layer stack constitutes said silicon dioxide film (14).

3. The method according to claim 2, wherein said planarizing step includes exposing the upper surface of the first component (12).

4. The method according to claim 3, wherein the planarizing step includes simultaneously thinning the first component (12) and the layer stack (9).

5. The method according to any one of the preceding claims, wherein the first component (12) and the second component (22) are different types of semiconductor components.

6. The method according to claim 5, wherein the first component is a silicon CMOS chip (12) and wherein the second component is a III-V chip (22).

7. The method according to claim 6, wherein the method further comprises the step of attaching an antenna chip (24) to the III-V chip (22), after said III-V chip has been bonded to said first redistribution layer (3).

8. The method according to any one of the preceding claims, further comprising the step of producing one or more through dielectric vias (15) through the thickness of the silicon dioxide film (14).

9. The method according to any one of the preceding claims, wherein the first and/or the second component (12,22) are bonded respectively to said one and said other of the redistribution layers (3,10) by hybrid bonding.

10. The method according to any one of claims 1 to 8, wherein the first and/or the second component (12,22) are bonded respectively to said one and said other of the redistribution layers (3,10) by solder bonding.
